(19) **Europäisches Patentamt / European Patent Office / Office européen des brevets**

(11) **EP 2 207 044 B1**

(12) # EUROPEAN PATENT SPECIFICATION

(45) Date of publication and mention of the grant of the patent:
**04.09.2013 Bulletin 2013/36**

(51) Int Cl.:
*H03D 13/00* (2006.01)     *G01R 27/28* (2006.01)
*G01R 25/00* (2006.01)

(21) Application number: **09795678.3**

(22) Date of filing: **08.07.2009**

(86) International application number:
**PCT/CN2009/072689**

(87) International publication number:
**WO 2010/048817 (06.05.2010 Gazette 2010/18)**

(54) **A SIGNAL PHASE DIFFERENCE MEASUREMENT METHOD, APPARATUS AND SYSTEM**

VERFAHREN, SYSTEM UND VORRICHTUNG ZUR MESSUNG EINER SIGNALPHASENDIFFERENZ

SYSTÈME, APPAREIL ET PROCÉDÉ DE MESURE DE DIFFÉRENCE DE PHASE DE SIGNAUX

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **27.10.2008 CN 200810171246**

(43) Date of publication of application:
**14.07.2010 Bulletin 2010/28**

(73) Proprietor: **Huawei Technologies Co., Ltd.
Longgang District, Shenzhen
Guangdong 518129 (CN)**

(72) Inventors:
• **SUN, Dawei
  Guangdong 518129 (CN)**
• **TIAN, Yuzhou
  Guangdong 518129 (CN)**
• **FENG, Enbo
  Guangdong 518129 (CN)**

• **TANG, Li
  Guangdong 518129 (CN)**
• **REN, Xiongwei
  Guangdong 518129 (CN)**

(74) Representative: **Epping - Hermann - Fischer
Patentanwaltsgesellschaft mbH
Ridlerstrasse 55
80339 München (DE)**

(56) References cited:
**CN-A- 1 946 071          CN-B- 1 010 538
JP-A- 57 200 870        US-A1- 2003 057 965
US-A1- 2005 111 606   US-A1- 2008 253 481**

• **ZHOU,YIPING: 'DESIGN FEATURES ANALYSIS FOR A SINGLE CHANNEL CORRELATION INTERFEROMETER' CHINESE WIRELESS April 2008,**

**Description**

Field of the invention

Embodiments of the present invention relate to the signal measurement technology, and in particularly, to a method, system and apparatus for measuring signal phase difference.

Background

In the technical field of testing, communication and controlling, it is a common case to measure phase information between multiple signals in a network.

In the conventional measuring process, a method of using multiple channels to sample multiple signals is usually employed. This method includes steps as follows:

First, each of the signal sampling channels is tested and calibrated, that is, to calculate and store transmission characteristic of each signal sampling channel to eliminate the influence caused by the transmission characteristic of each signal sampling channel on the final measurement result, so that amplitude-frequency characteristics and phase-frequency characteristics may be obtained as primary transmission characteristic. Then multiple sampling channels sample each of the signals at the same time, perform pre-processing such as amplification and filtering on the sampled signals, and then perform Analog-to-digital conversion(A/D conversion). Lastly, an information processing module extracts phase of each of the signals and phase difference between each of the signals may be obtained through processing; in this step, the measurement result needs to be calibrated according to the transmission characteristic of each of the channels.

The inventor found in the research of the invention that, there are at least following problems in the conventional art: in the above measurement process, a devoted sampling channel needs to be arranged for each of the signals, i.e. the number of the channels needs to match that of the signals; and therefore, the hardware density is obviously increased, system performance is deteriorated due to channel coupling ; meanwhile, the cost of the hardware goes up and different sampling channels have different amplifier and filter circuits. Due to the variance of elements and transmission characteristic of each of the signal sampling channels, especially the great variance of phase-frequency characteristics, the transmission characteristic of each of the channels needs to be sampled first, and measurement result needs to be calibrated. In conclusion, according to the conventional art, multiple channels are used to sample multiple signals, thereby increasing the hardware density and making the measurement procedure complicated;

Document US 2003/0057965 relates to a measuring apparatus and a measuring method that are less subjected to influences of the noise, the spurious, etc. with a simple configuration when a phase delay characteristic between an input signal and an output signal of a measured device such as an optical communication component, or the like is measured.

Summary

Various embodiments of the present invention provide a method, apparatus and system for measuring signal phase difference, in order to reduce the hardware density of apparatus and simplify the measuring procedure during the measuring of the phase difference of multiple signals.

One embodiment of the present invention provides a method for measuring signal phase difference. The method includes: sampling, by one sampling channel, at least two signals, and obtaining amplitude information of the sampled signals; and calculating out information of phase difference between the signals according to the amplitude information of the sampled signals; wherein the process of calculating out information of phase difference between the signals according to the amplitude information of the sampled signals comprises:

establishing a vector relation diagram of vectors associated with each of the signals according to the amplitude information of the sampled signals;
parsing the vector relation diagram to obtain the information of phase difference between each of the signals; wherein the process of parsing the vector relation diagram to obtain the information of phase difference between each of the signals comprises:

calculating out angles between the vectors of each of the signals in the vector relation diagram by using cosine law, the angle being the phase difference between the signals corresponding to two neighboring vectors;
wherein the process of sampling at least two signals, and obtaining amplitude information of the sampled signals comprises:

connecting the signals to be sampled to the sampling channel on a time segment basis;
sampling each of the signals by turn; and
performing A/D conversion to the sampled signal and obtaining amplitude information of the sampled signal from the signal undergoing A/D conversion.

One embodiment of the present invention provides an apparatus for measuring signal phase difference. The apparatus includes: a sampling module comprising at least one sampling channel responsible for sampling at least two signals; an amplitude information obtaining module, configured to obtain amplitude information of sampled signals obtained by said at least one sampling channel; and a calculating module, configured to calculate out phase difference information between signals according to the amplitude information; the calculating module comprises:

a vector relation diagram establishing unit, configured to establish according to the amplitude information of the signals the vector relation diagram of vectors corresponding to each of the sampled signals; and
a parsing unit, configured to parse the vector relation diagram of vectors corresponding to each of the signals to obtain the phase difference between each of the signals;
the parsing unit being further configured to calculate out angles between the vectors of each of the signals in the vector relation diagram by using cosine law, the angle being the phase difference between the signals corresponding to two neighboring vectors;
wherein the sampling module (1) comprises:

a connecting control unit (11), configured to connect on a time segment basis signals to be measured to one sampling channel; and
a signal sampling unit (12), configured to sample each connected signal by turn.

One embodiment of the present invention provides a system for measuring signal phase difference. The system includes: a transmission network bearing at least two signals to be measured; and the apparatus for measuring signal phase difference.

According to the method, apparatus and system, multiple signals are sampled by using one channel, the amplitude information of each of the signals is obtained and the phase relation between the signals is obtained by calculating according to amplitude information. Therefore, hardware density of the apparatus is reduced and the measuring procedure is simplified.

Brief Description of the Drawings

The accompanying drawings are illustrated herein for the ease of understanding the present invention and construed as a part of the invention, but not to limit the scope of the present invention. Among the drawings:

Fig. 1 is a schematic flow chart of a method for measuring signal phase difference according to the present invention;
Fig. 2 is a schematic structure view of an apparatus for measuring signal phase difference according to one embodiment of the present invention;
Fig. 3 is a schematic structure view of an apparatus for measuring signal phase difference according to another embodiment of the present invention;
Fig. 4 is a schematic structure view of a system for measuring signal phase difference according to the present invention;
Fig. 5 is a schematic structure view of a transmission network according to one embodiment of the present invention;
Fig. 6 is a schematic structure view of a signal phase difference measuring apparatus according to one embodiment of the present invention; and
Fig. 7 is a vector relation diagram according to one embodiment of the present invention.

Detailed Description of the Embodiments

For the purpose of making the technical solutions, objectives and advantages of the present invention clearer, the present invention is described further in detail by reference to embodiments and drawings. It should be appreciated that all the embodiments illustrate the present invention, not to limit the invention.

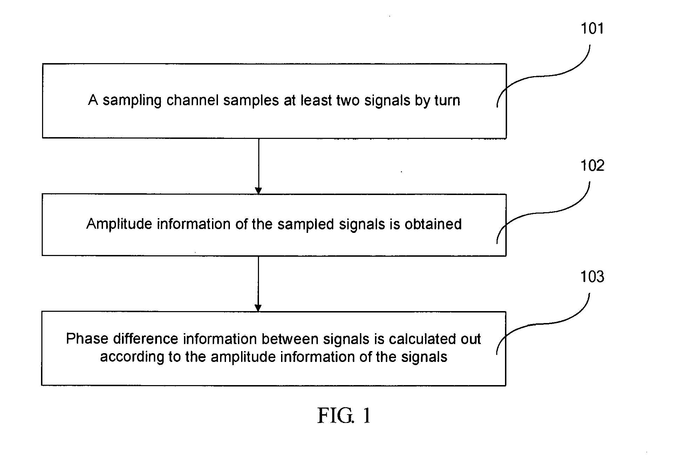

The method for measuring signal phase difference provided in an embodiment of the present invention is applicable in a system where amplitude and phase difference of multiple signals in the same network need to be measured. Fig. 1 is a schematic flow chart of a method for measuring signal phase difference according to the present invention. As shown in Fig. 1, the measuring procedure includes steps as follows:

101: A sampling channel samples at least two signals by turn.
102: Amplitude information of the sampled signals is obtained.
103: Phase difference information between signals is calculated out according to the amplitude information of the signals.

According to this embodiment, in the process of measuring the phase of multiple signals, one sampling channel is selected to sample by turn several signals. The signals are sampled by using the same channel on a time segment basis, the amplitude information is firstly obtained, and then the phase difference information is calculated out according to the amplitude information. In the processing of using the same sampling channel to sample at least two signals, the number of the sampling channels may be reduced, and therefore the hardware density may be reduced, and steps for characteristic sampling of the sampling channel and for calibrating the signals are decreased.

According to the above embodiment, in the process of using one sampling channel to sample at least two signals, a connecting control unit connects the signals to be sampled to the sampling channel on a time segment basis, and each of the connected signals is sampled by turn to obtain the amplitude information of the connected signals. After each of the connected signals is sampled, pre-processing of amplifying and filtering may be further performed to the signals. Moreover, the sampling channels are flexibly set according to practical situation, for example, setting only one channel for the sampling of all the signals, or setting two or more than two channels for sampling of part of the signals respectively. In other words, all the connected signals are sectioned into groups and each group of the connected signals corresponds to a sampling channel, so that different sampling channels may sample their corresponding connected signals.

As for the signals sampled by the same sampling channel, the way to obtain their amplitude information is to firstly perform an A/D conversion on the sampled signals, and then obtain the amplitude information from the signals undergoing the A/D conversion.

After the amplitude information of the signals is obtained, the vector relation diagram corresponding to vectors of each of the signals is established according to the amplitude information of the signals. The vector relation diagram is analyzed to obtain the phase difference information between each of the signals, in which the cosine law is used to calculate out angles between the vectors of each of the signals in the vector relation diagram, and the value of the angle is the phase difference between the signals corresponding to two neighboring vectors.

In the above embodiment, one sampling channel is used to sample by turn multiple signals and store their amplitude information, a vector relation diagram is established according to the amplitude information of each of the signals, and the phase difference information between each of the signals is obtained by calculating out the angles between the vectors of each of the signals according to the cosine law. According to this method, one sampling channel is used for the sampling of multiple signals, which reduces the hardware density of the measurement apparatuses, and simplifies the procedure for measuring the phase difference. Besides, one channel avoids the coupling of channels and enhances the performance of the system.

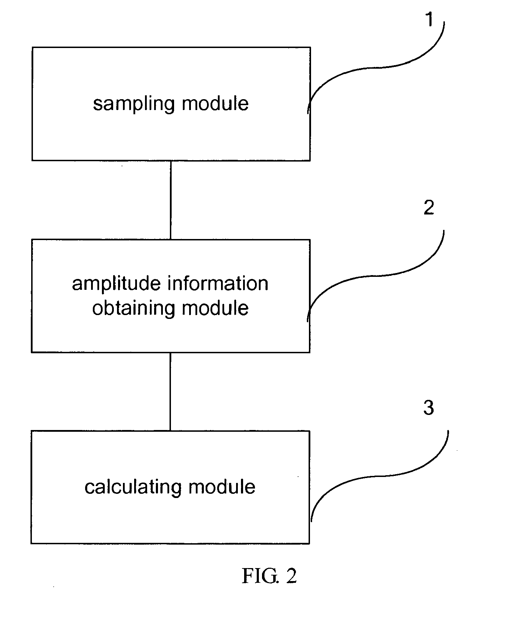

Figure 2 is a schematic structure view of an apparatus for measuring signal phase difference according to one embodiment of the present invention. The apparatus includes: a sampling module 1, an amplitude information obtaining module 2 and a calculating module 3. The sampling module 1 includes at least one sampling channel responsible for sampling at least two signals. In other words, the sampling module 1 includes multiple sampling channels and each of the channels may perform sampling on a group of signals; or one sampling channel samples by turn all the signals. As for the signals sampled simultaneously by different sampling channels, the phase difference information may be obtained by calculating the phase information directly extracted, or by calculating the phase information extracted by the amplitude information obtaining module 2. For the signals sampled by one sampling channel on a time segment basis, the amplitude information needs to be obtained by the amplitude information obtaining module 2, and then the calculating module 3 calculates out the phase difference information between each of the signals according to the amplitude information of the signals.

In the above embodiment, one sampling channel is used to sample multiple signals, which reduces the number of the sampling channels and the hardware density of the measurement apparatus. For the signals sampled by the same sampling channel, the transmission characteristic is consistent; therefore calibration is not needed for the signals, which simplifies the procedure for measuring the phase difference.

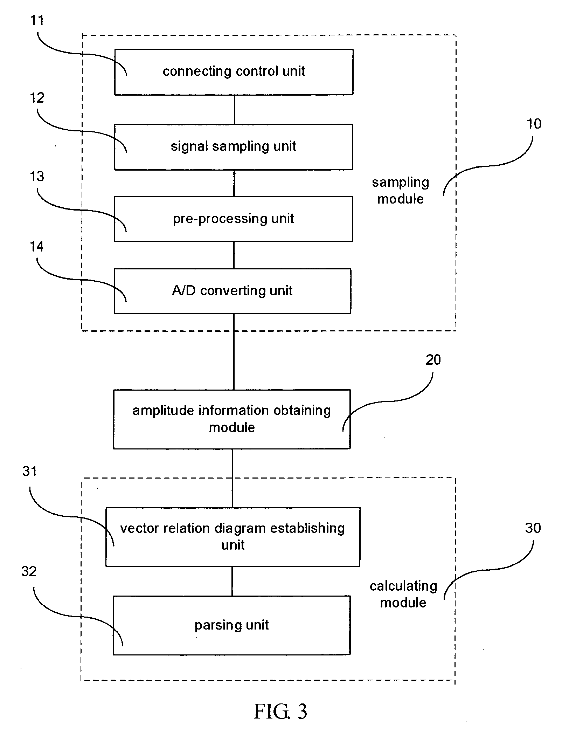

Fig. 3 is a schematic structure view of an apparatus for measuring signal phase difference according to another embodiment of the present invention. The apparatus includes a sampling module 10, an amplitude information obtaining module 20, and a calculating module 30.

The sampling module 10 includes: a connecting control unit 11, and a signal sampling unit 12. The connecting control unit 11 is configured to connect the signals to be measured to one of the sampling channels on a time segment basis. The signal sampling unit 12 is configured to sample each connected signal by turn. Further, the sampling module 10 may include: a pre-processing unit 13, and an A/D converting unit 14. The pre-processing unit 13 is configured to perform pre-processing of amplification and filtering. The A/D converting unit is configured to perform A/D conversion to the sampled signals.

In the embodiment, the sampling module 10 may be provided with multiple sampling channels which at least include a sampling channel capable of sampling multiple signals. The sampling module 10 may also be provided with one sampling channel and this sampling channel may be used to sample all the signals by turn.

As for the signals sampled simultaneously by different sampling channels, the phase difference information may be obtained by calculating the phase information directly extracted, or by calculating the phase information extracted by the amplitude information obtaining module 20. For the signals sampled by one sampling channel on a time segment basis, the amplitude information needs to be obtained by the amplitude information obtaining module 20. The amplitude information obtaining module 20 may obtain the amplitude information of the signals from signals undergoing A/D conversion.

The calculating module 30 includes: a vector relation diagram establishing unit 31, and an analysis unit 32. The vector relation diagram establishing unit 31 is configured to establish, according to the signal amplitude information obtained by the signal amplitude information obtaining module 20, the vector relation diagram of vectors corresponding to each of the signals. The analysis unit 32 is configured to analyze the vector relation diagram of the vector corresponding to each of the signals to obtain the phase difference information between each of the signals.

In this embodiment, one sampling channel is used to sample by turn multiple signals and store their amplitude information. A vector relation diagram is established according to the amplitude information of each of the signals. The phase difference is obtained by calculating the angles between vectors using cosine law. According to the above method for measuring signal phase difference, only one sampling channel is used for the sampling of multiple signals, which reduces the hardware density and simplifies the procedure for phase difference measurement. Besides, using one sampling channel may avoid the coupling of channels and enhance the system performance.

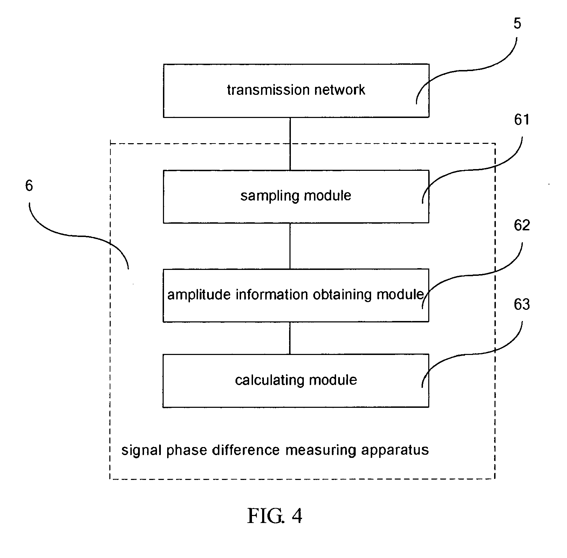

Fig. 4 is a schematic structure view of a system for measuring signal phase difference according to the present invention. The system includes: a transmission network 5, and a signal phase difference measuring apparatus 6. The transmission network bears at least two signals to be measured. The signal phase difference measuring apparatus 6 may include: a sampling module 61, an amplitude information obtaining module 62, and a calculating module 63, where the sampling module 61 includes at least one sampling channel for the sampling of at least two signals; the amplitude information obtaining module 62 is configured to obtain amplitude information of the sampled signals; and the calculating module 63 is configured to calculate out the phase difference information between signals according to the amplitude information of the signals.

In this embodiment, using one sampling channel to sample multiple signals reduces the number of the sampling channels in the signal difference measuring apparatus, and hence reduce hardware density of the apparatus and save the calibration procedure for the signals sampled in the same sampling channel. Therefore, operation is simplified greatly. According to this embodiment, the transmission network is a time-invariant network in a stable operation state.

The implementation of the signal phase difference measuring apparatus 6 may be referred to the description in the above embodiment. Specifically, the sampling module shown in Fig. 4 may be divided into a connecting control unit, a signal sampling unit, a pre-processing unit, and an A/D converting unit. The connecting control unit is configured to connect the signals to be measured to the same sampling channel on a time segment basis. The signal sampling channel is configured to sample each of the signals by turn. The pre-processing unit is configured to perform pre-processing of amplification and filtering on the sampled signals. The A/D converting unit is configured to perform A/D conversion on the sampled signals. The amplitude information obtaining module obtains from signals undergoing the A/D conversion the amplitude information of the sampled signals. The calculating module consists of a vector relation diagram establishing unit and a parsing unit. The vector relation diagram establishing unit establishes according to the amplitude information of the signals the vector relation diagram of vectors corresponding to each of the signals. The parsing unit parses the vector relation diagram of vectors corresponding to each of the signals to obtain the phase difference between each of the signals.

In the above method, apparatus and system provided in the embodiments of the present invention, only one sampling channel is used to sample multiple signals and the phase difference information is obtained by calculation. The detail is illustrated as follows by reference to an embodiment.

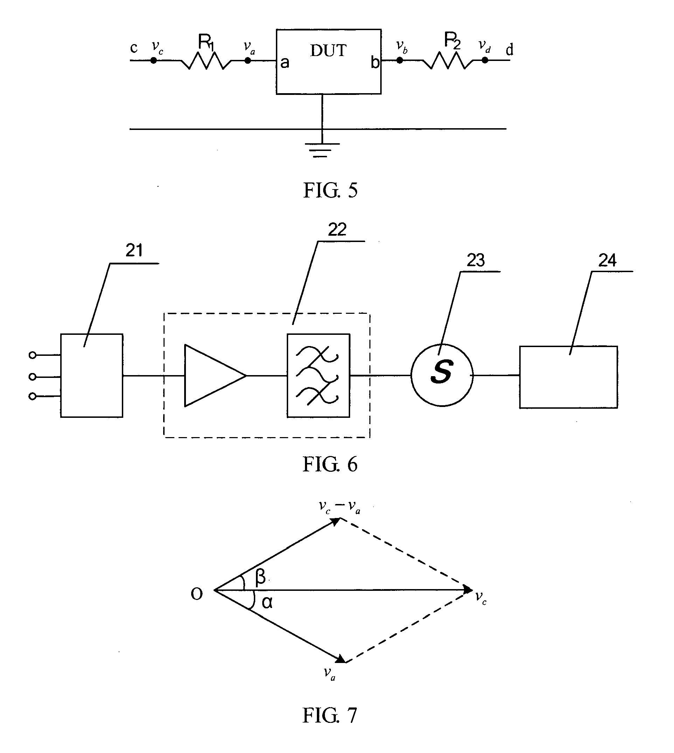

Fig. 5 is a schematic structure view of a transmission network according to one embodiment of the present invention. In this embodiment, a dual-port network impedance matrix testing model is illustrated. DUT is a network being measured or a apparatus being measured. Two lines with two resistant R1 and R2 are connected to port a and port b of the DUT. A steady-state excitation source is set on the c side and an open circuit is set on the d side. Signals $v_c$ and $v_a$ are obtained on the two sides of the R1, and signals $v_b$ and $v_d$ are obtained on the two sides of the R2. The impedance between a and c is represented by $Z_{11}$, the impedance between b and c is represented by $Z_{21}$. $Z_{11} = R_1 * v_a / (v_c - v_a)$, and $Z_{21} = R_1 * v_b/(v_c - v_a)$. For the purpose of obtaining the plural form of $Z_{11}$, besides the testing of the amplitude of $v_a$ and $(v_c - v_a)$, phase difference between $v_a$ and $(v_c - v_a)$ at the same moment needs to be tested. As described in the background, in the conventional art two sampling channels are used for the measurement of the phase difference between $v_a$ and $(v_c - v_a)$, that is, measuring $v_a$ and $(v_c - v_a)$ respectively, or measuring $v_a$ and $v_c$ to obtain $(v_c - v_a)$ by

subtraction.

An embodiment of the present invention provides a method for using one sampling channel to sample multiple signals so as to obtain their phase differences. Fig. 6 is a schematic structure view of a signal phase difference measuring apparatus according to one embodiment of the present invention. The apparatus includes: a signal sampling module 21, a pre-processing module 22, an A/D converting module 23, and a signal processing module 24. The signal sampling module 21 includes three sampling ports respectively responsible for measuring $v_a$, $v_c$ and ($v_c$ -$v_a$). After sampling each of the signals, the signal sampling module 21 sends the signals to the pre-processing module 22 for amplification and filtering. Then the A/D converting module performs A/D conversion on the signals and sends the conversion result to the signal processing module 24. The signal processing module 24 obtains the amplitude information of each of the signals and calculates out the phase difference according to the amplitude information of each of the signals.

Suppose the network to be measured is modeled by resistor and capacitor elements, as shown in Fig.7 illustrating a vector relation diagram, the three vectors respectively represents signals $v_a$, $v_c$ and ($v_c$-$v_a$), the three vector corresponding to the signals are represented by $v_a$, $v_c$ and ($v_c$-$v_a$). The vector ($v_c$-$v_a$) is the difference of the vectors $v_a$ and $v_c$. The magnitude of the vector is equal to the value of the amplitude of each of the signals. In the Figure, $\alpha$ is the angle between the vectors $v_a$ and $v_c$, $\beta$ is the angle between the vectors $v_c$ and ($v_c$ - $v_a$) , a+$\beta$ is the angle between the vectors $v_a$ and ($v_c$ -$v_a$) , and meanwhile is the phase difference between the signals $v_a$ and ($v_c$ -$v_a$). Referring to the Figure, it is obtained by the cosine law:

$$\cos\alpha = (|v_c|^2 + |v_a|^2 - |v_c - v_a|^2)/(2*|v_c|*|v_a|)$$

$$\cos\beta = (|v_c - v_a|^2 + |v_c|^2 - |v_a|^2)/(2*|v_c - v_a|*|v_c|)$$

sin $\alpha$ and sin $\beta$ may be calculated out according to the range of the angles $\alpha$ and $\beta$. It may be further obtained:

$\sin(\alpha + \beta) = \sin \alpha * \cos \beta + \cos \alpha * \sin \beta$
$\cos(\alpha + \beta) = \cos \alpha * \cos \beta - \sin \alpha * \sin \beta$
where $\alpha + \beta$ is the phase difference between the signals $v_a$ and ($v_c$-$v_a$) and therefore parameter $Z_{11}$ is:

$$Z_{11} = R_1 * \frac{|v_a|}{|v_c - v_a|} * (\cos(\alpha + \beta) + j * \sin(\alpha + \beta))$$

As for the testing of $Z_{21}$, the phase difference between the signals may be obtained by calculation according to the above method.

In the above embodiment, one sampling channel is used to sample multiple signals; only the amplitude information of the sampled signals needs to be stored; and the phase difference of the signals is obtained establishing the vector relation diagram of vectors of the signals and calculating the angles between the vectors. Therefore, the number of the sampling channels is reduced, the hardware density is reduced; system performance deterioration caused by the coupling of channels may be avoided; the error caused by different transmission characteristics is eliminated; the process of calibration may be omitted and the procedure of measuring the signal phase difference is simplified.

According to the description of the embodiments, it is understandable to those skilled in the art that all or part of the steps in the foregoing embodiments may be implemented by hardware instructed by a program. The program may be stored in a computer-readable storage medium such as a Read Only Memory (ROM), a Random Access Memory (RAM), a magnetic disk, or a Compact Disk (CD).

Although the invention has been described through several exemplary embodiments, the invention is not limited to such embodiments. It is apparent that those skilled in the art can make modifications and variations to the invention without departing from the scope of the invention as defined in the claims. The invention is intended to cover the modifications and variations provided that they fall in the scope of protection defined by the following claims or their equivalents.

**Claims**

1. A method for measuring signal phase difference, comprising:

   sampling, by one sampling channel, at least two signals (101), and obtaining amplitude information of the sampled signals (102); and
   calculating out information of phase difference between the signals according to the amplitude information of the sampled signals (103);
   wherein the process of calculating out information of phase difference between the signals according to the amplitude information of the sampled signals comprises:

   establishing a vector relation diagram of vectors associated with each of the signals according to the amplitude information of the sampled signals;
   parsing the vector relation diagram to obtain the information of phase difference between each of the signals;
   wherein the process of parsing the vector relation diagram to obtain the information of phase difference between each of the signals comprises:

   calculating out angles between the vectors of each of the signals in the vector relation diagram by using cosine law, the angle being the phase difference between the signals corresponding to two neighboring vectors;
   wherein the process of sampling at least two signals, and obtaining amplitude information of the sampled signals comprises:

   connecting the signals to be sampled to the sampling channel on a time segment basis;
   sampling each of the signals by turn; and
   performing A/D conversion to the sampled signal and obtaining amplitude information of the sampled signal from the signal undergoing A/D conversion.

2. The method of claim 1, **characterized in that** after sampling each of the signals by turn, the method further comprises:

   amplifying and pre-filtering the sampled signal.

3. An apparatus for measuring signal phase difference, comprising:

   a sampling module (1) comprising at least one sampling channel responsible for sampling at least two signals;
   an amplitude information obtaining module (2), configured to obtain amplitude information of sampled signals obtained by said at least one sampling channel; and
   a calculating module (3), configured to calculate out phase difference between
   signals according to the amplitude information;
   wherein the calculating module (3) comprises:
   a vector relation diagram establishing unit (31), configured to establish a vector relation diagram of vectors corresponding to each of the signals according to the amplitude information of the sampled signals; and
   a parsing unit (32), configured to parse the vector relation diagram of vectors corresponding to each of the signals to obtain the phase difference between each of the signal;
   the being parsing unit (32) being further configured to calculate out angles between the vectors of each of the signals in the vector relation diagram by using cosine law, the angle being the phase difference between the signals corresponding to two neighboring vectors;
   wherein the sampling module (1) comprises:

   a connecting control unit (11), configured to connect on a time segment basis signals to be measured to one sampling channel; and
   a signal sampling unit (12), configured to sample each connected signal by turn.

4. The apparatus of claim 3, **characterized in that** the sampling module (1) further comprises:

   a pre-processing unit (13), configured to perform pre-processing of amplification and filtering; and
   an A/D converting unit (14), configured to perform A/D conversion to the sampled signals;
   wherein the amplitude information obtaining module (2) obtains the amplitude information of the sampled signals from the signals undergoing A/D conversion.

**5.** A system for measuring signal phase difference, comprising:

a transmission network (5) bearing at least two signals to be measured; and
an apparatus of claim 3.

**6.** The system of claim 5 **characterized in that** the sampling module (1) further comprises:

a pre-processing unit (13), configured to configured to perform pre-processing of amplification and filtering;
an A/D converting unit (14), configured to perform A/D conversion to the sampled signals;
wherein the amplitude information obtaining module (2) obtains the amplitude information of the sampled signals from the signals undergoing A/D conversion.

**7.** The system of claim 5, **characterized in that** the transmission network (5) is a steady-state network.

**Patentansprüche**

**1.** Verfahren zur Messung einer Signalphasendifferenz, das die folgenden Schritte aufweist:

Abtasten von mindestens zwei Signalen (101) durch einen Abtastkanal und Erhalten von Amplitudeninformationen der abgetasteten Signale (102); und
Berechnen von Informationen der Phasendifferenz zwischen den Signalen gemäß den Amplitudeninformationen der abgetasteten Signale (103);
wobei der Prozess des Berechnens von Informationen der Phasendifferenz zwischen den Signalen gemäß den Amplitudeninformationen der abgetasteten Signale Folgendes aufweist:

Herstellen eines Vektorbeziehungsdiagramms von Vektoren, die jeweils mit den Signalen verbunden sind, gemäß den Amplitudeninformationen der abgetasteten Signale;
Parsen des Vektorbeziehungsdiagramms, um die Informationen der Phasendifferenz jeweils zwischen den Signalen zu erhalten;

wobei der Prozess des Parsens des Vektorbeziehungsdiagramms, um die Informationen der Phasendifferenz jeweils zwischen den Signalen zu erhalten, Folgendes aufweist:

Berechnen von Winkeln zwischen den Vektoren jedes der Signale im Vektorbeziehungsdiagramm mittels des Kosinusgesetzes, wobei der Winkel die Phasendifferenz zwischen den Signalen ist, die zwei benachbarten Vektoren entsprechen;

wobei der Prozess des Abtastens von mindestens zwei Signalen und des Erhaltens von Amplitudeninformationen der abgetasteten Signale Folgendes aufweist:

Verbinden der abzutastenden Signale mit dem Abtastkanal auf einer Zeitabschnittsbasis;
abwechselndes Abtasten jedes der Signale; und
Durchführen einer A/D-Wandlung am abgetasteten Signal und Erhalten von Amplitudeninformationen des abgetasteten Signals aus dem Signal, das einer A/D-Wandlung unterzogen wird.

**2.** Verfahren nach Anspruch 1, **dadurch gekennzeichnet, dass** nach dem abwechselnden Abtasten jedes der Signale das Verfahren ferner Folgendes aufweist:

Verstärken und Vorfiltern des abgetasteten Signals.

**3.** Vorrichtung zur Messung einer Signalphasendifferenz, die Folgendes aufweist:

ein Abtastmodul (1), das mindestens einen Abtastkanal aufweist, der für das Abtasten von mindestens zwei Signalen zuständig ist;
ein Amplitudeninformationserhaltungsmodul (2), das konfiguriert ist, Amplitudeninformationen der abgetasteten Signale zu erhalten, die durch den mindestens einen Abtastkanal erhalten werden; und
ein Berechnungsmodul (3), das konfiguriert ist, eine Phasendifferenz zwischen Signalen gemäß den Amplitudeninformationen zu berechnen;
wobei das Berechnungsmodul (3) Folgendes aufweist:

eine Vektorbeziehungsdiagramm-Herstellungseinheit (31), die konfiguriert ist, ein Vektorbeziehungsdiagramm von Vektoren, die jeweils den Signalen entsprechen, gemäß den Amplitudeninformationen der abgetasteten Signale herzustellen; und
eine Parsingeinheit (32), die konfiguriert ist, das Vektorbeziehungsdiagramm von Vektoren zu parsen, die jeweils den Signalen entsprechen, um die Phasendifferenz jeweils zwischen den Signalen zu erhalten;
wobei die Parsingeinheit (32) ferner konfiguriert ist, Winkel zwischen den Vektoren jedes der Signale im Vektorbeziehungsdiagramm mittels des Kosinusgesetzes zu berechnen, wobei der Winkel die Phasendifferenz zwischen den Signalen ist, die zwei benachbarten Vektoren entsprechen;

wobei das Abtastmodul (1) Folgendes aufweist:

eine Verbindungssteuereinheit (11), die konfiguriert ist, auf einer Zeitabschnittsbasis zu messende Signale mit einem Abtastkanal zu verbinden; und
eine Signalabtasteinheit (12), die konfiguriert ist, abwechselnd jedes verbundene Signal abzutasten.

4. Vorrichtung nach Anspruch 3, **dadurch gekennzeichnet, dass** das Abtastmodul (1) ferner Folgendes aufweist:

eine Vorverarbeitungseinheit (13), die konfiguriert ist, eine Vorverarbeitung einer Verstärkung und Filterung durchzuführen; und
eine A/D-Wandlereinheit (14), die konfiguriert ist, eine A/D-Wandlung an den abgetasteten Signalen durchzuführen;
wobei das Amplitudeninformationserhaltungsmodul (2) die Amplitudeninformationen der abgetasteten Signale aus den Signalen erhält, die der A/D-Wandlung unterzogen werden.

5. System zur Messung einer Signalphasendifferenz, das Folgendes aufweist:

ein Übertragungsnetzwerk (5), das mindestens zwei zu messende Signale trägt; und
eine Vorrichtung nach Anspruch 3.

6. System nach Anspruch 5, **dadurch gekennzeichnet, dass** das Abtastmodul (1) ferner Folgendes aufweist:

eine Vorverarbeitungseinheit (13), die konfiguriert ist, eine Vorverarbeitung einer Verstärkung und Filterung durchzuführen;
eine A/D-Wandlereinheit (14), die konfiguriert ist, eine A/D-Wandlung an den abgetasteten Signalen durchzuführen;
wobei das Amplitudeninformationserhaltungsmodul (2) die Amplitudeninformationen der abgetasteten Signale aus den Signalen erhält, die der A/D-Wandlung unterzogen werden.

7. System nach Anspruch 5, **dadurch gekennzeichnet, dass** das Übertragungsnetzwerk (5) ein stationäres Netzwerk ist.

**Revendications**

1. Procédé de mesure d'une différence de phase entre signaux, comprenant :

l'échantillonnage, par un canal d'échantillonnage, d'au moins deux signaux (101), et l'obtention d'informations d'amplitude des signaux échantillonnés (102) ; et
le calcul d'informations de différence de phase entre les signaux en fonction des informations d'amplitude des signaux échantillonnés (103) ;
le processus de calcul d'informations de différence de phase entre les signaux en fonction des informations d'amplitude des signaux échantillonnés comprenant :

l'établissement d'un diagramme de relation vectorielle de vecteurs associés à chacun des signaux en fonction des informations d'amplitude des signaux échantillonnés ;

la décomposition du diagramme de relation vectorielle afin d'obtenir les informations de différence de phase entre chacun des signaux ;

le processus de décomposition du diagramme de relation vectorielle afin d'obtenir les informations de différence de phase entre chacun des signaux comprenant :

le calcul d'angles entre les vecteurs de chacun des signaux dans le diagramme de relation vectorielle en utilisant une loi en cosinus, l'angle étant la différence de phase entre les signaux correspondant à deux vecteurs voisins ;

le processus d'échantillonnage d'au moins deux signaux, et l'obtention d'informations d'amplitude des signaux échantillonnés comprenant :

la connexion des signaux à échantillonner au canal d'échantillonnage sur la base de segments temporels ; l'échantillonnage tour à tour de chacun des signaux ; et l'exécution d'une conversion A/N sur le signal échantillonné et l'obtention d'informations d'amplitude du signal échantillonné à partir du signal soumis à la conversion A/N.

2. Procédé selon la revendication 1, **caractérisé en ce qu'**après l'échantillonnage tour à tour de chacun des signaux, le procédé comprend en outre :

l'amplification et le pré-filtrage du signal échantillonné.

3. Appareil de mesure de la différence de phase entre signaux, comprenant :

un module d'échantillonnage (1) comprenant au moins un canal d'échantillonnage responsable de l'échantillonnage d'au moins deux signaux ; un module d'obtention d'informations d'amplitude (2), configuré pour obtenir des informations d'amplitude de signaux échantillonnés obtenus par ledit au moins un canal d'échantillonnage ; et un module de calcul (3), configuré pour calculer la différence de phase entre des signaux en fonction des informations d'amplitude ; le module de calcul (3) comprenant :

une unité d'établissement de diagramme de relation vectorielle (31) configurée pour établir un diagramme de relation vectorielle de vecteurs correspondant à chacun des signaux en fonction des informations d'amplitude des signaux échantillonnés ; et une unité de décomposition (32), configurée pour décomposer le diagramme de relation vectorielle de vecteurs correspondant à chacun des signaux afin d'obtenir la différence de phase entre chacun des signaux ; l'unité de décomposition (32) étant en outre configurée pour calculer des angles entre les vecteurs de chacun des signaux dans le diagramme de relation vectorielle en utilisant une loi en cosinus, l'angle étant la différence de phase entre les signaux correspondant à deux vecteurs voisins ;

le module d'échantillonnage (1) comprenant :

une unité de commande de connexion (11), configurée pour connecter, sur la base de segments temporels, des signaux à mesurer à un canal d'échantillonnage ; et une unité d'échantillonnage de signal (12), configurée pour échantillonner tour à tour chaque signal connecté.

4. Appareil selon la revendication 3, **caractérisé en ce que** le module d'échantillonnage (1) comprend en outre :

une unité de prétraitement (13), configurée pour effectuer un prétraitement d'amplification et de filtrage ; une unité de conversion A/N (14) configurée pour exécuter une conversion A/N sur les signaux échantillonnés ; le module d'obtention d'informations d'amplitude (2) obtenant les informations d'amplitude des signaux échantillonnés à partir des signaux soumis à la conversion A/N.

5. Système de mesure d'une différence de phase entre signaux, comprenant :

un réseau de transmission (5) acheminant au moins deux signaux à mesurer ; et
un appareil selon la revendication 3.

6. Système selon la revendication 5, **caractérisé en ce que** le module d'échantillonnage (1) comprend en outre :

une unité de prétraitement (13), configurée pour exécuter un prétraitement d'amplification et de filtrage ;
une unité de conversion A/N (14), configurée pour effecteur une conversion A/N sur les signaux échantillonnés ;
le module d'obtention d'informations d'amplitude (2) obtenant les informations d'amplitude des signaux échantillonnés à partir des signaux soumis à la conversion A/N.

7. Système selon la revendication 5, **caractérisé en ce que** le réseau de transmission (5) est un réseau de régime stationnaire.

101

A sampling channel samples at least two signals by turn

102

Amplitude information of the sampled signals is obtained

103

Phase difference information between signals is calculated out according to the amplitude information of the signals

FIG. 1

FIG. 2

11

connecting control unit

12

signal sampling unit

13

pre-processing unit

14

A/D converting unit

10

sampling module

20

amplitude information obtaining module

31

vector relation diagram establishing unit

32

parsing unit

30

calculating module

FIG. 3

FIG. 4

FIG. 5

FIG. 6

FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20030057965 A